# EUROPÄISCHE PATENTANMELDUNG

(11) **EP 1 972 947 A2**
(43) Veröffentlichungstag der Anmeldung: **24.09.2008**
(21) Anmeldenummer: 07017182.2
(22) Anmeldetag: 01.09.2007
(51) Int. Cl.: G01R 15/18, B60L 9/16

(54) **Vorrichtung zur Messung eines von einem Wechselstromanteil überlagerten Gleichstromanteils eines in Leitern von Wechselstrombahnen fliessenden Stroms**

(30) Priorität: 19.03.2007 DE 102007013634
(71) Anmelder: Balfour Beatty PLC, London SW1V 1LQ (GB)
(72) Erfinder: Zynovchenko, Andriy, 63067 Offenbach (DE); Schulz, Peter, 63743 Aschaffenburg (DE)
(74) Vertreter: Luderschmidt, Schüler & Partner

(57) **Zusammenfassung**

Die erfindungsgemäße Vorrichtung zur Messung eines Gleichstromariteils in einem Betriebsstrom einer Wechselstrombahn verfügt über einen ersten Strommesswandler 8 zum Messen des in dem mindestens einen Leiter 5 der Wechselstrombahn fließenden Stroms. Der erste Strommesswandler 8 kann sowohl einen Gleichanteil als auch einen Wechselanteil des in dem Leiter 5 fließenden Stroms erfassen. Die erfindungsgemäße Messvornchtung zeichnet sich durch einen zweiten Strommesswandler 10 aus, der im Gegensatz zu dem ersten Strommesswandler 8 nur den Wechselstromanteil, nicht aber den Gleichstromanteil des in dem Leiter fließenden Stroms erfasst. Der zweite Strommesswandler 10 wirkt derart mit dem ersten Strommesswandler 8 zusammen, dass durch den in der Sekundärwicklung 11 des zweiten Strommesswandlers fließenden Strom der Wechselanteil des Magnetfeldes, das von dem durch den Leiter fließenden Strom erzeugt wird, in dem ersten Strommesswandler 8 kompensiert wird, so dass der erste Strommesswandler nur den Gleichstromanteil, nicht aber den Wechselstromanteil des durch den Leiter fließenden Stroms erfasst. Aufgrund der Kompensation der Wechselkomponente braucht der erste Strommesswandler 8 nicht auf die großen Betriebsströme, die mehrere tausend Ampere betragen können, ausgelegt zu werden. Der erste Strommesswandler kann daher auf den viel kleineren Gleichanteil in dem Betriebsstrom ausgelegt werden. Dadurch wird die Genauigkeit der Messung der Gleichkomponente deutlich erhöht.

## Beschreibung

Die Erfindung betrifft eine Vorrichtung zur Messung eines von einem Wechselstromanteil überlagerten Gleichstromanteils eines in Leitern von Wechselstrombahnen fließenden Stroms, wobei der Gleichstromanteil im Verhältnis zu dem Wechselstromanteil sehr klein ist.

Für den Energietransport zu den Triebfahrzeugen wird die Spannung des speisenden Hochspannungsnetzes in den Unterwerken auf die Fahrleiterspannung herabgesetzt.

Bei den bekannten Einspannungssystemen wird die Energie über Oberleitungen oder Stromschienen dem Triebfahrzeug zugeführt und über die Fahrschienen und andere verfügbare Rückleiter sowie das Erdreich zurückgeleitet.

Neben den Einspannungssystemen sind auch Zweispannungssysteme bekannt, mit denen sich die Übertragungsleistungen erhöhen und die Spannungsabfälle längs der Fahrleitungen reduzieren lassen. Sie bestehen aus dem Kettenwerk als den so genannten Positivfeeder (PF), den längs der Strecke angeordneten Autotransformatoren (AT) und einem zusätzlichen Energieleiter, den so genannten Negativfeeder (NF).

Sowohl in Einspannungs- als auch Mehrspannungssystemen können durch die Einwirkungen der benachbarten Gleichstrombahnen Gleichströme entstehen. Gleichströme in Anlagen von Wechselstrombahnen sind grundsätzlich unerwünscht, da sie neben einer verstärkten Korrosion der Erdungseinrichtungen und der Beeinflussung der Gleichstromgleisstromkreise auch zur Sättigung der Leistungstransformatoren führen (Meyer, M.: Wechselwirkungen Energieversorgung - Triebfahrzeug bei AC-Bahnen. In: Elektrische Bahnen 103 (2005) 4-5, S. 213-218).

Bei Wechselstrombahnsystemen können zufällige Verbindungen der Gleichstrombahnrückleitung mit dem Erdreich, die unentdeckt bleiben können, zu einer weiteren Erhöhung der Gleichstromanteile führen.

Durch die Sättigung eines Transformators entstehen in seinem Eisenkern lokale Bereiche mit einer verstärkten Blecherwärmung, die auch als hot spots bezeichnet werden. Die Bildung von hot spots als Folge der verstärkt auftretenden Wirbelströme kann schließlich zum Ausfall des Transformators führen.

Zu den negativen Wirkungen der Gleichströme zählen auch die Geräuschentwicklung, die Beeinträchtigung des Leistungsdurchlassvermögens des Transformators sowie die Entstehung von geradzahligen Harmonischen der Netzfrequenz, die Gleisstromkreise beeinflussen können, beispielsweise die weitverbreiteten 100 Hz Gleisstromkreise in 16,7 Hz Netzen.

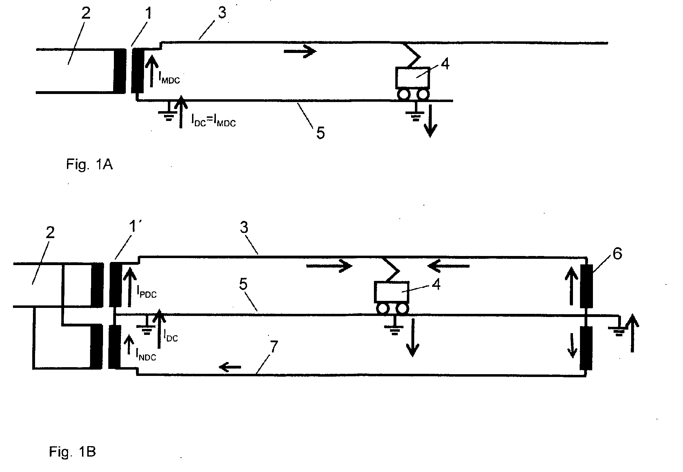

Obwohl der ohmsche Widerstand der Oberleitung wesentlich größer als der der Fahrschienen oder des Erdreichs ist, fließt ein beträchtlicher Anteil des Gleichstroms aus den Fahrschienen und dem Erdreich über elektrische Triebfahrzeuge und Transformatoren in die Oberleitung an einer Stelle hin, breitet sich in der Oberleitung aus und fließt an einer anderen Stelle wiederum über Triebfahrzeuge und Transformatoren in die Fahrschienen bzw. das Erdreich zurück (Fig. 1A und 1B).

Während Betriebsströme bei Wechselstrombahnen üblicherweise in der Größenordnung von mehreren tausend Ampere liegen können, sollte der maximal zulässige Gleichstrom nur in einer Größenordnung von wenigen Ampere liegen oder noch kleiner sein. Zum Beispiel liegen die Grenzwerte für den Gleichstromanteil bei einem 50 Hz 66 MVA 170/25 kV Zweispannungstransforrnator laut Herstellerangaben im Bereich zwischen 0,38 und 2,24 A in Abhängigkeit von der anliegenden Primärspannung und der Dauer des Stromflusses. Zum Schutz der Transformatoren bei Wechselstrombahnen sollte der magnetisierende Gleichstrom I_{MDC} des Transformators gemessen und überwacht werden. Es ist aber sehr schwierig, den im Verhältnis zum Wechselstromanteil sehr kleinen Gleichstromanteil mit ausreichender Genauigkeit zu messen.

Zum Messen von Wechselströmen werden in Bahnstromnetzen standardmäßig nach dem Induktionsprinzip arbeitende Stromwandler eingesetzt. Derartige Stromwandler können aufgrund ihres Funktionsprinzips nur Wechselströme erfassen.

Die bekannten nach dem Induktionsprinzip arbeitenden Stromwandler verfügen über einen Magnetkern mit einer Primär- und Sekundärwicklung, wobei die Primärwicklung von dem Leiter der Wechselstrombahn gebildet wird, die durch den Magnetkern des Wandlers geführt wird, was einer Wicklung mit einer Windung entspricht. Die Sekundärwicklung ist eine Messwicklung, deren Strom umgekehrt proportional zum Verhältnis der Anzahl der Windungen der Primär- und Sekundärwicklung verringert wird und mit verfügbaren Messinstrumenten gemessen oder in elektronischen Schaltungen ausgewertet werden kann.

Aus der DE 197 06 127 C2 ist eine Vorrichtung zum Messen von Strom bekannt, die über zwei induktive Stromwandler mit antiparallel geschalteten Dioden in den Sekundärstromkreisen der Wandler verfügt. Wenn im Primärstrom ein Gleichstromanteil vorhanden ist, sind Unterschiede zwischen der positiven und der negativen Stromhalbwelle zu beobachten, die im Messkreis der Vorrichtung erfasst und ausgewertet werden. Bei der Messung kleiner Gleichströme erweisen sich zum einen die nur kleinen Unterschiede zwischen den Halbwellen als nachteilig, die von der Auswerteinrichtung nur schwer erfasst werden können. Zum anderen werden die Unterschiede zwischen den Halbwellen nicht durch den primärseitig fließenden Gleichstrom, sondern auch von Abweichungen in den Stromspannungskennlinien der Dioden oder der Übertragungscharakteristiken der Stromwandler verursacht. Folglich ist die bekannte Vorrichtung für die Messung eines im Verhältnis zu dem Wechselstromanteil sehr kleinen Gleichstromanteils nicht geeignet.

Als nachteilig erweist sich bei der bekannten Vorrichtung auch die mangelhafte Kurzschlussfestigkeit, die auf die geringe Überlastbarkeit der Dioden im Kurzschlussfall sowie auf die Gefahr der Entstehung hoher Rückwärtsspannungen zurückzuführen ist, die bei gesperrten Dioden auftreten können.

Neben den induktiven Stromwandlern sind auch optische Stromwandler bekannt, die auf dem Faraday-Effekt beruhen, d.h. der Drehung der Polarisationsebene von Licht bei bestimmten Materialien unter dem Einfluss eines Magnetfeldes (DE 69424496T2, EP0430060B1, DE 19802191B4, DE 19945576A1).

Bei den bekannten optischen Stromwandlern wird die magneto-optisch induzierte Drehung der Polarisationsebene des Lichtes in elektrische Signale umgewandelt, die einer Auswerteinheit zugeführt werden. Aus dem Funktionsprinzip derartiger Stromwandler ergibt sich, dass der zeitliche Verlauf des Stroms erfasst wird. Ist nur eine bestimmte Frequenzkomponente des Stroms von Interesse, muss diese mittels elektrischer Filter in der Auswerteinheit extrahiert werden. Für die Messung von kleinen Gleichstromanteilen ist von Nachteil, dass der Betriebswechselstrom von dem Sensor erfasst wird, wobei der Sensor und die Auswerteinheit für den maximalen Momentanwert des Gesamtstroms dimensioniert werden müssen. Aufgrund des kleinen Frequenzabstands und des großen Amplitudenunterschieds zwischen dem Gleichstrom und dem Betriebsstrom muss die Ordnung des Gleichstromfilters entsprechend hoch sein. Aufgrund der zahlreichen elektronischen Bauelemente sowie ihrer Auslegung auf den Maximalwert des Gesamtstroms ist ein DC-Offset im Ausgangssignal vorhanden, der zum Teil vom Betriebsstrom abhängt. Bei hohen Betriebsströmen kann der DC-Offset die Größe des dem zu messenden Gleichstromanteil entsprechenden Nutzsignals erreichen.

Darüber hinaus sind Messverfahren bekannt, die nach dem Prinzip der Magnetflusskompensation arbeiten. Diese Messverfahren werden auch als so genannte Zero-flux-Verfahren bezeichnet. Die nach dem Prinzip der Magnetflusskompensation arbeitenden Stromwandler verfügen über eine oder mehrere sekundärseitig angebrachte Kompensationswicklungen, in die ein Strom eingespeist wird. Der eingespeiste Kompensationsstrom wird so geregelt, dass der Magnetfluss im Wandlerkern vorzugsweise vollständig kompensiert wird. Der Kompensationsstrom stellt somit eine Nachbildung des Primärstroms dar und wird als Spannungsabfall über einen Messwiderstand erfasst und in einer Auswerteinheit ausgewertet. Für die Einstellung des Kompensationsstroms wird ein Steuer- bzw. Rückführsignal benötigt. Dieses kann beispielsweise mittels eines im Wandlerkern angebrachten Hall-Sensors gewonnen werden (DE 4202296B4, EP 0194225B1). Da ein Hall-Sensor sowohl ein stationäres als auch ein sich zeitlich veränderndes durch den Primärstrom im Wandlerkern erzeugtes Magnetfeld misst, wird von dem Hall-Sensor auch der Gleichstromanteil im Primärstrom erfasst.

Es sind nach dem Prinzip der Magnetflusskompensation arbeitende Stromwandler bekannt, bei denen das Steuersignal mittels einer zusätzlich sekundärseitig angebrachten Hilfswicklung erzeugt wird (DE 4310361A1, JP 09171935). Zur Erfassung des Gleichstromanteils im Primärstrom können zusätzliche Eisenkerne eingesetzt werden, deren Magneteigenschaften bereits im Arbeitsbereich nicht linear sind. Bei der Messung von kleinen Gleichströmen haben die Messwandler nach dem Prinzip der Magnetflusskompensation hinsichtlich ihrer Messgenauigkeit die gleichen Nachteile wie die optischen Stromwandler. Anstelle der Fehler der Auswerteinheit eines optischen Stromwandlers treten in einem nach dem Prinzip der Magnetflusskompensation arbeitenden Stromwandler die Fehler bei der Erzeugung des Steuersignals für die Einstellung des Kompensationsstroms auf.

Die derzeitigen Entwicklungen bei den bekannten Stromwandlern richten sich im Wesentlichen auf die Erweiterung der Bandbreite der Messwandler sowie die Verbesserung der Messgenauigkeit für hochfrequente Stromkomponenten. Nachteilig ist jedoch, dass die bekannten Stromwandler nicht die Messung von Gleichstromkomponenten in Betriebsströmen von Wechselstrombahnen mit ausreichender Genauigkeit erlauben, die im Verhältnis zu den Wechselstromkomponenten der Betriebsströme klein sind.

Der Erfindung liegt daher die Aufgabe zugrunde, eine Vorrichtung zu schaffen, die eine Messung eines von einem Wechselstromanteil überlagerten Gleichstromanteils eines in Leitern von Wechselstrombahnen fließenden Stroms insbesondere auch dann mit hoher Genauigkeit erlaubt, wenn der Gleichstromanteil im Verhältnis zum Wechselstromanteil sehr klein ist.

Die Lösung dieser Aufgabe erfolgt erfindungsgemäß mit den im Patentanspruch 1 angegebenen Merkmalen. Vorteilhafte Ausführungsformen der Erfindung sind Gegenstand der Unteransprüche.

Die hohe Messungenauigkeit bei der Messung sehr kleiner Gleichstromanteile mit den bekannten Stromwandlern ist darauf zurückzuführen, dass nicht nur die zu messende Gleichstromkomponente, sondern auch die Wechselstromkomponente durch die bekannten Stromwandler erfasst wird.

Die erfindungsgemäße Vorrichtung zur Messung eines Gleichstromanteils in einem Betriebsstrom einer Wechselstrombahn verfügt über einen ersten Strommesswandler zum Messen des in dem mindestens einen Leiter der Wechselstrombahn fließenden Stroms. Der erste Strommesswandler erfasst sowohl einen Gleichanteil als auch einen Wechselanteil des Magnetfelds, das von dem in dem Leiter fließenden Strom erzeugt wird, und misst somit sowohl einen Gleichanteil als auch einen Wechselanteil des Leiterstroms.

Als Strommesswandler zum Messen des Gleich- und Wechselanteils des Betriebsstroms können alle handelsüblichen Strommesswandler eingesetzt werden, mit denen nicht nur Wechselströme, sondern auch Gleichströme gemessen werden können. Diese Strommesswandler verfügen bekanntlich über eine Primärwicklung und eine Sekundärwicklung, wobei der Leiter der Wechselstrombahn die Primärwicklung des Strommesswandlers bildet. Beispielsweise können die als Stand der Technik beschriebenen Stromwandler verwendet werden, die nach dem zero-flux-Prinzip oder nach dem Faraday-Effekt arbeiten.

Die erfindungsgemäße Messvorrichtung zeichnet sich durch einen zweiten Strommesswandler aus, der im Gegensatz zu dem ersten Strommesswandler nur den Wechselstromanteil, nicht aber den Gleichstromanteil des in dem Leiter fließenden Stroms erfasst. Der zweite Strommesswandler wirkt derart mit dem ersten Strommesswandler zusammen, dass durch den in der Sekundärwicklung des zweiten Strommesswandlers fließenden Strom der Wechselanteil des Magnetfeldes, das von dem durch den Leiter fließenden Strom erzeugt wird, in dem ersten Strommesswandler kompensiert wird, so dass der erste Strommesswandler nur den Gleichstromanteil, nicht aber den Wechselstromanteil des durch den Leiter fließenden Stroms erfasst. Der zweite Strommesswandler stellt somit eine Kompensationseinrichtung für die Wechselkomponente des Magnetfelds im ersten Strommesswandler dar.

Aufgrund der Kompensation des Wechselanteils des Magnetfelds mit Hilfe des zweiten Strommesswandlers braucht der erste Strommesswandler nicht auf die großen Betriebsströme, die mehrere tausend Ampere betragen können, ausgelegt zu werden. Der erste Strommesswandler kann daher auf den viel kleineren Gleichanteil in dem Betriebsstrom ausgelegt werden. Dadurch wird eine ausreichende Genauigkeit bei der Messung der Gleichstromkomponente erreicht. Diese Kompensation ist grundsätzlich unabhängig von dem Messprinzip des ersten Stromwandlers für die Erhöhung dessen Messgenauigkeit von Vorteil.

Bei einer bevorzugten Ausführungsform, die sich durch einen einfachen Aufbau auszeichnet, weist der erste Strommesswandler einen ersten Magnetkern auf, während der zweite Strommesswandler einen zweiten Magnetkern aufweist. Der erste Magnetkern wird von einer Kompensationswicklung umschlossen, während der zweite Magnetkern von einer Sekundärwicklung umschlossen wird. Die Kompensationswicklung des ersten Strommesswandlers und die Sekundärwicklung des zweiten Strommesswandlers sind derart miteinander verbunden, dass der in der Kompensationswicklung des ersten Strommesswandlers fließende Strom gegensinnig zu dem durch den Leiter der Wechselstrombahn fließenden Stroms gerichtet ist. Dadurch wird erreicht, dass der Wechselanteil des von dem ersten Strommesswandler erfassten Magnetfelds, der auf den Wechselstromanteil des in dem Leiter fließenden Stroms zurückzuführen ist, in dem ersten Strommesswandler kompensiert wird. Vorzugsweise wird eine vollständige Kompensation des Wechselanteils angestrebt.

Bei einer weiteren besonders bevorzugten Ausführungsform ist der Magnetkern des ersten und/oder zweiten Strommesswandlers ein mindestens einen Leiter der Wechselstrombahn umschließender Magnetkern.

Im Folgenden werden unter Bezugnahme auf die Zeichnungen zwei Ausführungsbeispiele der Erfindung näher erläutert.

Es zeigen:
- Fig. 1A: eine vereinfachte schematische Darstellung einer Einspannungsstrecke,
- Fig. 1B: eine vereinfachte schematische Darstellung einer Zweispannungsstrecke,
- Fig. 2A: ein Ausführungsbeispiel der erfindungsgemäßen Messvorrichtung zur Messung eines Gleichanteils im Betriebsstrom bei einem Einspannungssystem in vereinfachter schematischer Darstellung und
- Fig. 2B: ein Ausführungsbeispiel der erfindungsgemäßen Messvorrichtung zum Messen eines Gleichanteils im Betriebsstrom bei einem Zweispannungssystem in vereinfachter Darstellung.

Die Einspannungsstrecke umfasst einen Unterwerkstransforrnator 1 zum Herabsetzen der Spannung des Hochspannungsnetzes 2 auf die Fahrleitungsspannung. Die Energie wird über Oberleitungen 3 oder Stromschienen dem Triebfahrzeug 4 zugeführt und über Fahrschienen 5 sowie das Erdreich zurückgeleitet. Die Rückleitung 5 kann neben den Fahrschienen auch eventuell vorhandene Bahnrückleiter, Rückleitungsseile oder Rückleitungskabel etc. umfassen. Diese Rückleiter werden häufig auch unter dem Begriff Bahnerde zusammengefasst. (Fig. 1A).

Fig. 1B zeigt eine Mehrspannungsstrecke, im vorliegenden Fall ein Zweispannungssystem, wobei für die einander entsprechenden Baugruppen die gleichen Bezugszeichen wie bei dem unter Bezugnahme auf Fig. 1 beschriebenen Einspannungssystem verwendet werden. Das Zweispannungssystem weist im Unterwerk einen Haupttransformator 1' auf, der die notwendigen Potentiale für einen Positivfeeder (PF) und einen Negativfeeder (NF) zur Verfügung stellt und dessen Mittelanzapfung mit den Fahrschienen 5 verbunden und damit geerdet ist. Längs der Zweispannungsstrecke sind Spartransformatoren 6 angeordnet, die auch als Autotransformatoren (AT) bezeichnet werden. Neben dem Kettenwerk 3 als Positivfeeder (PF) weist das Zweispannungssystem einen zusätzlichen Energieleiter 7 auf, der gegen Erde aber das entgegengesetzte Potential wie das Kettenwerk aufweist. Dieser Energieleiter 7 wird deshalb auch als Negativfeeder (NF) bezeichnet. Die Mittelpunkte der Autotransformatoren 6 sind an die Fahrschienen 5 angeschlossen, während deren Außenanschlüsse mit dem Kettenwerk (PF) 3 und mit dem Negativfeeder (NF) 7 verbunden sind.

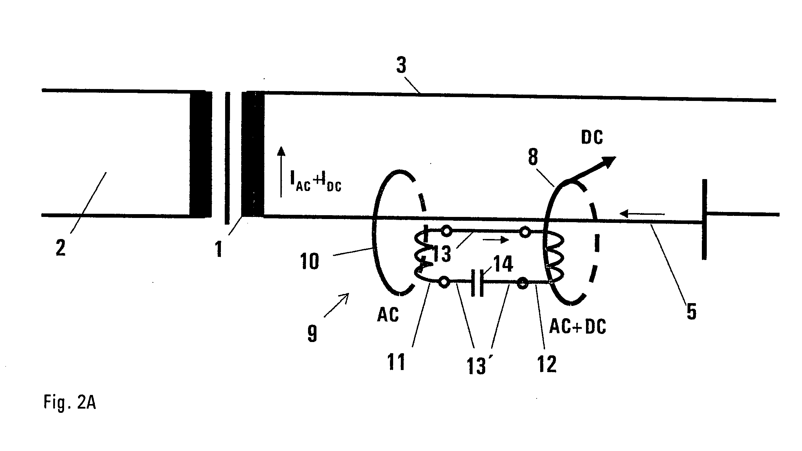

Nachfolgend wird die erfindungsgemäße Messvorrichtung zusammen mit der Einspannungsstrecke unter Bezugnahme auf Fig. 2A beschrieben. Der Betriebsstrom I in dem Einspannungssystem weist einen Wechselanteil I_{AC} und einen Gleichanteil I_{DC} auf. Der Betriebsstrom I = I_{AC} + I_{DC} strömt durch Hin- und Rückleitung 3, 5 des Einspannungssystems. Er erzeugt sowohl ein stationäres und als auch ein zeitlich sich veränderndes Magnetfeld, das beispielsweise die Rückleitung 5 konzentrisch umschließt.

Zum Messen des in dem Leiter fließenden Stroms, der sowohl einen Gleich- als auch Wechselanteil enthält, verfügt die erfindungsgemäße Messvorrichtung über einen ersten Strommesswandler, der sowohl den Gleichanteil als auch den Wechselanteil des durch den Leiter fließenden Stroms misst. Der erste Strommesswandler kann als handelsüblicher Stromwandler ausgebildet sein, der sowohl den Gleich- als auch Wechselanteil des Betriebsstroms messen kann. Beispielsweise kann ein Stromwandler eingesetzt werden, der nach dem Prinzip der Magnetflusskompensation arbeitet. Ein derartiger Stromwandler wird beispielsweise von der Firma Hitec Power Protection angeboten (Wandler HVI der Firma Hitec Power Protection, 7600 AB Almelo, The Netherlands; http://www.hitecsms.com).

Der erste Strommesswandler 8 (AC + DC) wird in der schematischen Darstellung als magnetischer Ringkern dargestellt, der die Rückleitung 5 konzentrisch umgibt. Dabei bildet die Rückleitung 5 eine Primärwicklung des ersten Stromwandlers 8. Der in der Primärwicklung fließende Strom erzeugt einen magnetischen Fluss im Ringkern 8. Der besseren Übersichtlichkeit halber sind die weiteren Komponenten des Stromwandlers, zu denen weitere Wicklungen und eine Auswerteinheit gehören, nicht dargestellt, da diese Komponenten für das Prinzip der Erfindung unwesentlich und ohnehin dem Fachmann als Stand der Technik bekannt sind.

Neben dem ersten Strommesswandler 8 weist die erfindungsgemäße Vorrichtung einen zweiten Strommesswandler 10 (AC) auf, der in der schematischen Darstellung wieder als magnetischer Ringkern dargestellt ist, wobei die Rückleitung 5 wieder die Primärwicklung des Strommesswandlers bildet. Der zweite Strommesswandler 10 zeichnet sich dadurch aus, dass nur der Wechselanteil, nicht aber der Gleichanteil des durch die Rückleitung 5 fließenden Stroms gemessen werden kann. Es kann also ein handelsüblicher Stromwandler, beispielsweise ein induktiver Stromwandler Verwendung finden, der nur den Wechselstrom misst.

Der Ringkern des zweiten Strommesswandlers 10 (AC) wird von einer Sekundärwicklung 11 umschlossen, während der Magnetkern des ersten Strommesswandlers 8 (AC + DC) von einer Kompensationswicklung 12 umschlossen wird. Die Kompensationswicklung 12 ist über Verbindungsleitungen 13, 13' an die Sekundärwicklung 11 angeschlossen. Die beiden Wicklungen sind derart miteinander verbunden, dass der in der Kompensationswicklung 12 fließende Strom gegensinnig zu dem durch die Rückleitung 5 fließenden Strom fließt, so dass mit der Kompensationswicklung ein Magnetfeld zur Kompensation des Wechselanteils des Magnetfelds in dem ersten Strommesswandler 8 erzeugt wird.

Das Funktionsprinzip der erfindungsgemäßen Vorrichtung liegt darin, dass die Wechselstromkomponente des in der Rückleitung 5 fließenden Stroms mit dem zweiten Strommesswandler (AC) 10 erfasst und in dem ersten Strommesswandler 8 (AC + DC) der Wechselanteil des auf die Wechselstromkomponente zurückzuführenden Magnetfelds, das von dem ersten Strommesswandler erfasst wird, vorzugsweise vollständig kompensiert wird. Dabei bleibt der von dem ersten Strommesswandler erfasste Gleichanteil des Magnetfelds unverändert.

Folglich misst der erste Strommesswandler 8 (AC + DC) nur den Gleichstromanteil, nicht jedoch den Wechselstromanteil des Betriebsstroms. Der erste Strommesswandler braucht also nicht auf den vollen Betriebsstrom, sondern nur auf den zu erwartenden Gleichstrom ausgelegt zu werden, wobei gegebenenfalls noch ein nicht vollständig kompensierter Restwechselstrom zu berücksichtigen ist. Im Hinblick auf die optimierte Dimensionierung des ersten Strommesswandlers innerhalb des kleineren Messbereichs ist eine deutliche Verbesserung der Messgenauigkeit auch für sehr kleine Gleichströme möglich.

Ein weiterer Vorteil liegt darin, dass an die Kurzschlussfestigkeit des ersten Strommesswandlers nicht so hohe Anforderungen gestellt werden müssen, da das magnetische Wechselfeld des Kurzschlussstroms durch diesen Wandler genauso wie dasjenige des Betriebsstroms kompensiert wird.

Die im Rahmen der Erfindung durchgeführten Labormessungen haben gezeigt, dass eine weitere Verbesserung der Messgenauigkeit und eine um das Mehrfache kürzere Sprungantwortzeit der Vorrichtung durch das Einschalten eines bipolaren Kondensators 14 in die Verbindungsleitung 13 oder 13' erzielt werden kann. Der optimale Kapazitätswert des Kondensators 14 hängt mit den Parametern der beiden Stromwandler zusammen und lässt sich auf rechnerische oder messtechnische Weise ermitteln.

Die Windungszahl der Kompensationswicklung 12 des ersten Strommesswandlers 8 (AC + DC) ergibt sich aus dem Übersetzungsverhältnis des zweiten Strommesswandlers 10 (AC). Wenn beispielsweise in der Primärwicklung, d.h. der Rückleitung 5 ein Primärstrom von 4000 A fließt und in der Sekundärwicklung 11 des zweiten Strommesswandlers 10 ein Sekundärstrom von 2 A fließt, muss die Kompensationswicklung 12 des ersten Strommesswandlers 8 2000 Windungen haben, um das von dem Primärstrom hervorgerufene Magnetwechselfeld zu kompensieren.

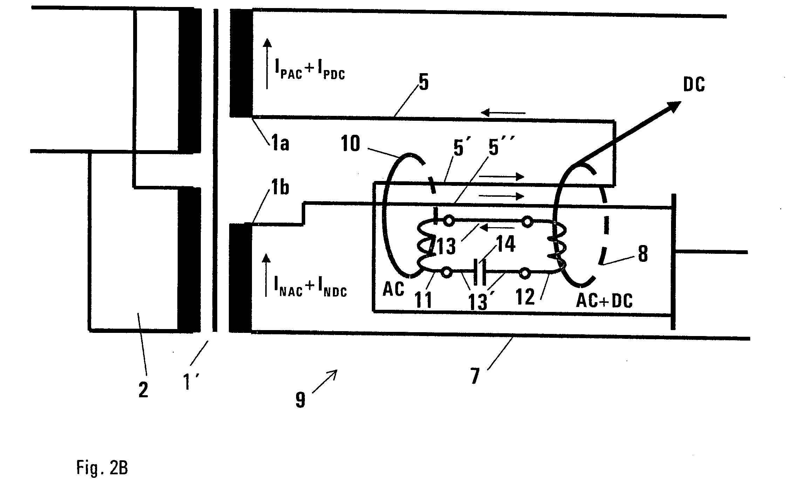

Fig. 2B zeigt die erfindungsgemäße Messvorrichtung zusammen mit einem Zweispannungssystem in vereinfachter schematischer Darstellung, wobei die gleichen Bezugszeichen wie in Fig. 2A verwendet werden. Die Anordnung von Fig. 2B unterscheidet sich von der Anordnung von Fig. 1A nur dadurch, dass die beiden Strommesswandler 8, 10 die zu den beiden Mittelanschlüssen 1 a und 1b des Transformators 1' führenden Leitungsabschnitte 5', 5" umschließen.

Bei Transformatoren mit mehreren Wicklungen, z.B. in Mehrspannungsnetzen, ist der magnetisierende Gleichstrom gleich der Summe der Ströme, die den Transformatorkern gleichsinnig magnetisieren (I_{MDC} = I_{PDC} + I_{NDC}). Daher sind beide Leitungsabschnitte 5', 5" derart geführt, dass die Ströme, die den Transformatorkern gleichsinnig magnetisieren, in der gleichen Richtung durch die Strommesswandler fließen. Um den Transformator zu schützen, sollte der magnetisierende Gleichstrom I_{MDC} eines Transformators vorzugsweise in seinen Rückleitern gemessen und überwacht werden.

Bei Überschreitung der Grenzwerte für den magnetisierenden Gleichstrom wird der Transformatorkern unzulässig übersättigt, so dass der Transformator abzuschalten ist. Für niedrigere Gleichstromanteile können Alarmmeldungen generiert werden.

## Patentansprüche

1. Vorrichtung zur Messung eines von einem Wechselstromanteil überlagerten Gleichstromanteils eines in Leitern von Wechselstrombahnen fließenden Stroms, mit einem ersten Strommesswandler (8) zum Messen des in dem mindestens einen Leiter (5) der Wechselstrombahn fließenden Stroms, wobei der erste Strommesswandler derart ausgebildet ist, dass der erste Strommesswandler einen Gleichstromanteil und einen Wechselstromanteil des in dem Leiter fließenden Stroms messen kann,
**dadurch gekennzeichnet, dass**
ein zweiter Strommesswandler (10), der nur einen Wechselstromanteil des in dem Leiter (5) fließenden Stroms erfasst, vorgesehen ist, wobei der zweite Strommesswandler (10) mit dem ersten Strommesswandler (8) derart zusammenwirkt, dass durch den in der Sekundärwicklung (11) des zweiten Strommesswandlers fließenden Strom der Wechselanteil des Magnetfeldes, das von dem durch den Leiter fließenden Strom erzeugt wird, in dem ersten Strommesswandler kompensiert wird, so dass der erste Strommesswandler (8) nur den Gleichstromanteil des durch den Leiter fließenden Stroms erfasst.

2. Vorrichtung nach Anspruch 1, **dadurch gekennzeichnet, dass** der erste Strommesswandler einen ersten Magnetkern (8) aufweist, der von einer Kompensationswicklung (12) umschlossen ist, und der zweite Strommesswandler einen zweiten Magnetkern (10) aufweist, der von einer Sekundärwicklung (11) umschlossen ist, wobei die Kompensationswicklung (12) des ersten Strommesswandlers und die Sekundärwicklung (11) des zweiten Strommesswandlers derart miteinander verbunden sind, dass der Strom in der Kompensationswicklung des ersten Strommesswandlers gegensinnig zu dem durch den Leiter (5) fließenden Strom fließt.

3. Vorrichtung nach Anspruch 2, **dadurch gekennzeichnet, dass** der Magnetkern des ersten und/oder zweiten Strommesswandlers (8, 10) ein mindestens einen Leiter (5) der Wechselstrombahn umschließender Magnetkern ist.

4. Vorrichtung nach Anspruch 2, **dadurch gekennzeichnet, dass** die Kompensationswicklung (12) des ersten Strommesswandlers und die Sekundärwicklung (11) des zweiten Strommesswandlers zur weiteren Verbesserung der Messgenauigkeit und zur Verkürzung der Sprungantwortzeit der Messvorrichtung über einen in Reihe geschalteten Kondensator (14) verbunden sind.
